(19) Europäisches Patentamt
European Patent Office
Office européen des brevets

(11) **EP 1 189 326 B1**

(12) **EUROPÄISCHE PATENTSCHRIFT**

(45) Veröffentlichungstag und Bekanntmachung des Hinweises auf die Patenterteilung:
**02.04.2008 Patentblatt 2008/14**

(51) Int Cl.:
*H02J 7/00* *(2006.01)*      *G01R 31/36* *(2006.01)*
*H01M 10/44* *(2006.01)*

(21) Anmeldenummer: **01116463.9**

(22) Anmeldetag: **07.07.2001**

(54) **Verfahren zur Überwachung der Ladung gasdichter alkalischer Akkumulatoren**

Method of monitoring charge of a gastight alkaline accumulator

Procédé de surveillancde de l'état de charge d'un accumulateur alcalin étanche

(84) Benannte Vertragsstaaten:
**AT BE CH CY DE DK ES FI FR GB GR IE IT LI LU MC NL PT SE TR**

(30) Priorität: **15.09.2000 DE 10045622**

(43) Veröffentlichungstag der Anmeldung:
**20.03.2002 Patentblatt 2002/12**

(73) Patentinhaber: **VARTA Automotive Systems GmbH**
**30419 Hannover (DE)**

(72) Erfinder: **Köhler, Uwe, Dr.**
**34131 Kassel (DE)**

(74) Vertreter: **Lins, Edgar et al**
**Gramm, Lins & Partner GbR**
**Theodor-Heuss-Strasse 1**
**38122 Braunschweig (DE)**

(56) Entgegenhaltungen:
**DE-A- 3 832 841          US-A- 4 677 363**
**US-A- 5 012 176          US-A- 5 710 501**

**Beschreibung**

Wiederaufladbare alkalische Batteriesysteme werden in großen Mengen für moderne Geräteanwendungen eingesetzt. Neben diesen Anwendungen wird in Zukunft auch verstärkt der Einsatz in Fahrzeugen, sei es als Antriebsbatterie in Hybridfahrzeugen oder als Bordnetzbatterie, treten. Hohe Leistungsabgabe und die Fähigkeit, elektrische Energie mit hoher Leistung effektiv rückzuspeichern, sind wesentliche Eigenschaften der alkalischen Systeme.

Von allen alkalischen Sekundärsystemen: Nikkel-Cadmium (NiCd), Nickel-Metallhydrid (NiMH), Nikkel-Zink(NiZn), Nickel-Eisen(NiFe) hat sich heute das Nickel-Metallhydrid-System als das System mit den besten Eigenschaften herausgebildet. Gegenüber anderen alkalischen Sekundärsystemen besitzt es bessere Ladungsaufnahme, längere Lebensdauer und vermeidet den gefürchteten "Memory Effekt". Zudem kommt es ohne giftige Schwermetalle aus.

Die Möglichkeiten der Schnellladung von alkalischen Sekundärsystemen reichen bis in den Bereich weniger Minuten. Begrenzt wird die Schnellladung durch die Überschreitung kritischer Zellspannungen, die durch die Zersetzungsspannung des Wassers bestimmt werden und Sauerstoffgasung an der positiven Elektrode, die in einer gasdichten alkalischen Zelle in ihrer Kapazität gegenüber der negativen Elektrode unterdimensioniert ist. Die Sauerstoffgasung an der positiven Elektrode erfolgt als parasitäre Reaktion, wenn die positive Elektrode sich dem Vollladezustand nähert und stellt die Ursache für die Notwendigkeit von Ladestrombegrenzungen dar.

Durch die Sauerstoffgasungsreaktion kann sich in der Zelle ein Druck aufbauen, der im Extremfall zum Ansprechen der Sicherheitsventile und zum Austritt von Ladegasen und Elektrolyt führt. Da sich beides schädigend auf die Lebensdauererwartung der gasdichten Zellen auswirken kann, ist es erstrebenswert, solche kritischen Ladezustände früh zu erkennen und die Ladeströme rechtzeitig zu begrenzen bzw. abzubrechen.

Das Erkennen der kritischen Ladezustände ist jedoch problematisch. Eine Druckmessung gilt als zu aufwendig. Als von außen an der Zelle messbare Größen stehen nur Zellspannung und -temperatur zur Verfügung. Da die Sauerstoff-Gasungsreaktionen bei gasdichten alkalischen Sekundärsystemen immer von einer exothermen Sauerstoff-Verzehrreaktion an der negativen Gegenelektrode begleitet ist, ist generell auch der in der Regel beobachtete zeitliche Temperaturanstieg ein Signal für die beginnende Gasung und damit den zellinternen Druckanstieg. Allerdings kann besonders bei sehr hohen Ladeströmen auf das Temperatursignal nur bedingt zurück gegriffen werden, da die hohe Wärmekapazität von wässrigen Batteriesystemen nur zu einem verhältnismäßig langsamen Anstieg der Temperatur als Folge einer beginnenden Überladung führt.

US 5,012,176 A offenbart ein Verfahren zur Bestimmung des Ladezustands einer wiederaufladbaren Batterie in Abhängigkeit von der Batterietemperatur und einem Ladeaufnahmemodell. Während des Ladeprozesses wird der maximale Ladezustand aus der Temperatur, dem Ladestrom und zwei Konstanten mit Hilfe einer Funktion des Modells für die aufnehmbare Ladung bestimmt. Die Funktion der aufnehmbaren Ladung über den Ladezustand kann beispielsweise aus Exponentialfunktionen für verschiedene Temperaturen bestehen.

Der Erfindung liegt daher die Aufgabe zugrunde, ein Verfahren zur Überwachung der Ladung und zur Bestimmung kritischer Ladezustände anzugeben, wobei lediglich Spannung und Temperatur des zu überwachenden Akkumulators gemessen und zur Beurteilung herangezogen werden.

Diese Aufgabe wird erfindungsgemäß bei einem Verfahren der eingangs genannten Gattung durch die Merkmale des kennzeichnenden Teils des Anspruchs 1 gelöst. In den Unteransprüchen sind vorteilhafte Ausgestaltungen des Verfahrens angegeben.

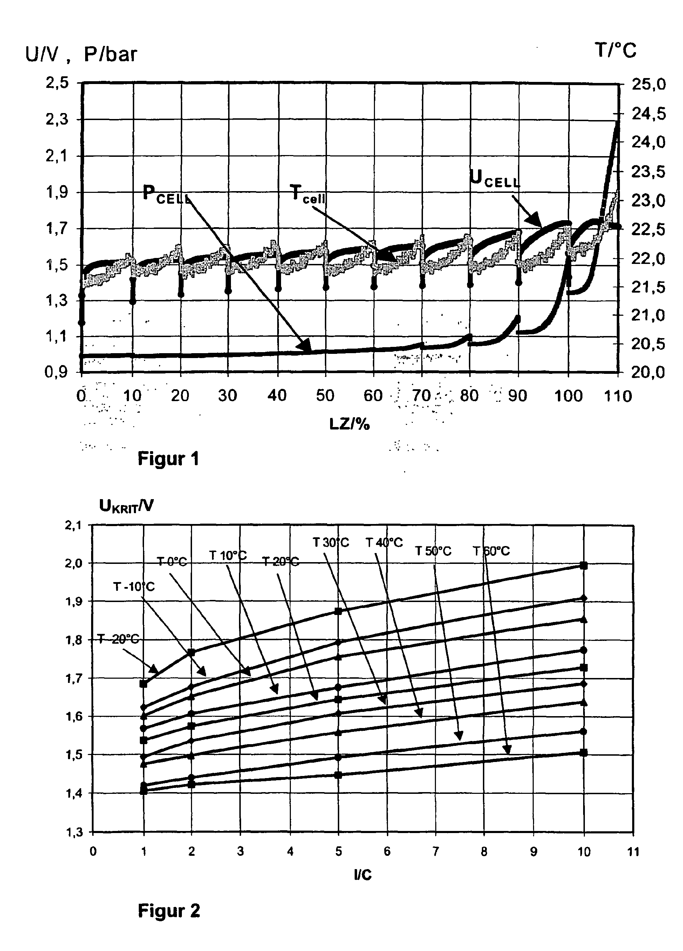

Im folgenden ist das erfindungsgemäße Verfahren anhand der Figuren 1 bis 6 näher erläutert.

Figur 1 zeigt den Spannungsverlauf $U_{CELL}$ das Druckverhalten $P_{CELL}$ und den Temperaturverlauf $T_{CELL}$ einer NiMH-Zelle mit einer Nennkapazität von 9Ah, die schrittweise mit 0,9 Ah-Ladungspulsen (10% der Kapazität) bei 20°C mit einer Stromstärke von 90A (10C-Rate) geladen wird. Nach Beendigung jedes einzelnen Ladeschritts verbleibt die Zelle für 30 Minuten in Ruhe, um mit der Umgebung einen Temperaturausgleich herbeizuführen und die Zelle wieder auf Ruhepotential, -temperatur und -druck zu bringen. Bei Überschreitung eines Ladezustands von 90 % ist im gezeigten Beispiel ein deutlicher Druckanstieg zu beobachten, der mit einem horizontalen Einschwenken des Spannungssignals $U_{CELL}$ einhergeht. Bei weiterem Laden sinkt unter weiterem Druckanstieg die Spannung sogar wieder leicht ab. Dieser Effekt ist als negative Delta U-Verschiebung (Depolarisation) bekannt und wird heute als Abschaltsignal vielfältig genutzt, wobei die Ladeströme aber in der Regel unterhalb des halbstündigen Nennstroms (2C-Rate) bleiben.

Hier und im folgenden sind die Belastungsströme des Akkumulators in C angegeben, d.h., ein Ladestrom von 1 C entspricht der Ladung eines Akkumulators mit einer Nennkapazität von 9 Ah mit einem Ladestrom von 9 A, eine Ladung mit 10 C einem Ladestrom von 90 A.

Der Wert des Spannungsmaximums, der mit dem Druckanstieg durch die Sauerstoffgasung bzw. dem Gasverzehrmechanismus an der negativen Elektrode korelliert, wird als kritische Spannungsgröße $U_{Krit}$ bezeichnet.

Führt man die in Figur 1 beschriebene Messung bei einer Vielzahl verschiedener Ströme und bei verschiedenen Temperaturen durch und definiert die dabei beobachteten Spannungsmaxima, die mit dem Druckanstieg korreliert sind, als zu diesen Parametern gehörende kritische Spannungswerte, so ergibt sich das in Figur 2 dargestellte Diagramm. Mit steigendem Ladestrom verschieben sich die $U_{krit}$-Werte zu höheren Spannungs-

werten. Niedrigere Temperaturen verursachen ebenfalls eine Verschiebung der kritischen Werte zu höheren Spannungen.

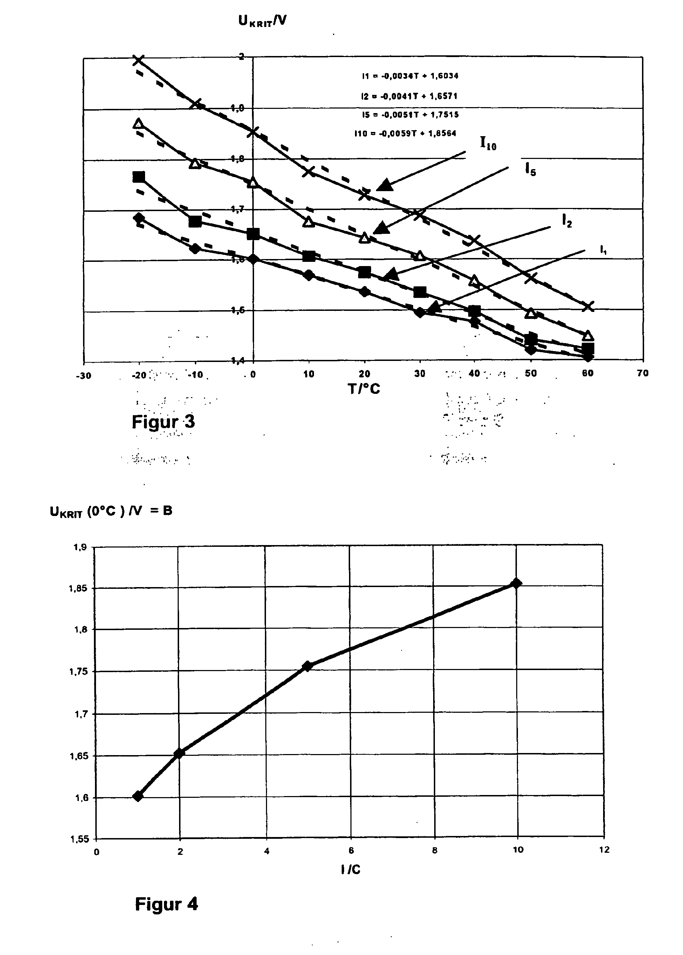

Der in Figur 3 gezeigte Zusammenhang zwischen kritischer Spannung $U_{krit}$ und Temperatur (mit den Ladeströmen in C als Parameter) zeigt nahezu lineare Verläufe, die durch einen einfachen mathematischen Zusammenhang der Form

$$U_{krit} = A(I) * T + B(I)$$

beschrieben werden können.

Der lineare Zusammenhang zwischen $U_{krit}$ und Temperatur, der in Figur 3 für Ladeströme von 1, 2, 5 und 10C dargestellt ist, aber auch für dazwischen liegende Ladeströme gilt, bedeutet, dass bei Kenntnis der Parameter A und B kritische Ladespannungen aus o.g. Zusammenhang berechnet werden können. Die kritischen Ladespannungswerte können als Referenzwerte im Batteriemonitoring-System berechnet und mit dem aktuellen Spannungswert des Systems verglichen werden. Überschreitet die aktuelle Ladespannung den kritischen Wert, werden Maßnahmen zur Ladestromabregelung ausgelöst. Dazu ist lediglich die Speicherung der Wertepaare A und B im Batteriemanagementsystem der Parameterfelder Voraussetzung.

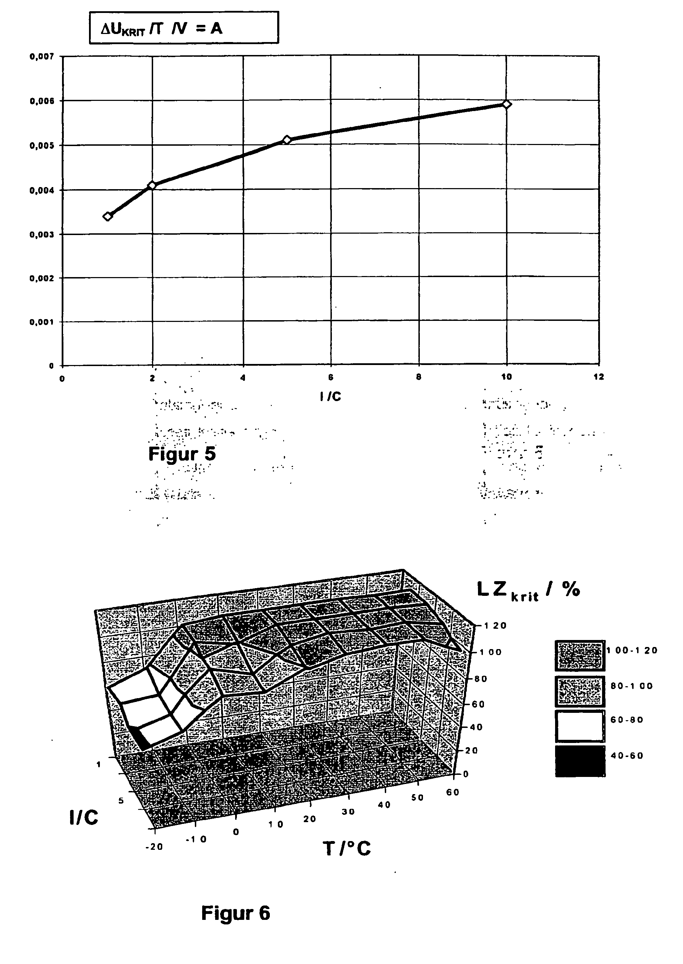

Beide Parameter A und B hängen vom Ladestrom (I) ab. Der Verlauf von A (Anstiegsrate) in Abhängigkeit von der Stromstärke I ist in Figur 5, der von B ist in Figur 4 grafisch dargestellt. Zur praktischen Verwendung werden beide Größen in tabellierter Form in einem Batteriemanagement-System als Parameter-Tabelle hinterlegt.

Der beschriebene Zusammenhang zwischen Temperatur, Ladestrom und kritischer Spannung kann umgekehrt auch zur Bestimmung des Ladezustands genutzt werden, da die kritischen Spannungswerte naturgemäß mit einem bestimmten kritischen Ladezustand ($LZ_{krit}$) korreliert sind, wie auch aus Figur 1 ersichtlich. Auch dieser kritische Ladezustand $LZ_{krit}$ ist wiederum eine Funktion der Parameter Temperatur (T) und Ladestrom (I). Figur 6 zeigt den Zusammenhang zwischen kritischem Ladezustand ($LZ_{krit}$). Temperatur und Ladestrom. Bei Erreichen einer kritischen Ladespannung $U_{krit}$, die, wie oben erläutert, ermittelt wird, kann aus den dieser Anzeige zugrunde liegenden I- und T-Werten mittels des in Figur 6 dargestellten dreidimensionalen Zusammenhangs auf den Ladezustand rückgeschlossen werden. Hieraus kann z.B. ein in der Regel auf Ladungsbilanzierung (Ah-Zähler) basierendes Ladezustands-Erfassungssystem ein "Reset" erfahren.

Das beschriebene Verfahren setzt allerdings den Eintritt des Kritikalitätskriteriums voraus. Dies kann unter kontrollierten Bedingungen dergestalt erfolgen, dass z. B. generell bei einer Inbetriebnahme des Fahrzeugs oder in bestimmten zeitlich definierten Intervallen oder nach bestimmten Ladungsdurchsätzen die Akkumulatorenbatterie als quasi entladen betrachtet wird. Durch entsprechende Ladungssteuerung wird eine Nettoladung (positiver Ladefaktor) solange durchgeführt bis das $U>U_{krit}$-Kriterium eintritt.

Der zu überwachende Akkumulator wird hierzu in vorgegebenen Zeiten bis auf die kritische Ladespannung $U_{krit}$ geladen. Entsprechend den Daten in Figur 6 wird dann aus Temperatur und Ladestrom, die zu diesem Ukrit-Wert gehören, der Ladezustand bestimmt. Tritt z.B. bei einer Temperatur von 0°C und einem Strom von 10C Spannungskritikalität ein, so kann daraus auf einen Ladezustand von 80% geschlossen werden. Bei 20°C und einem Strom von 10C bedeutet dagegen Kritikalität einen Ladezustand von annähernd 100%.

Der so ermittelte Ladezustand wird im Batteriemanagementsystem gespeichert und wird als Reset-Wert für eine Ladezustandskontrolle mittels zeitlicher Stromintegration verwendet. Eine solche Ladezustandsbestimmung kann in festen zeitlichen Intervallen oder nach Durchsatz einer bestimmten Ladungsmenge erfolgen.

**Patentansprüche**

1. Verfahren zur Überwachung der Ladung gasdichter alkalischer Akkumulatoren, **dadurch gekennzeichnet, dass** an einem Akkumulator die Kennlinien der kritischen Ladespannung ($U_{krit}$) als Funktion von Ladestrom (I) für verschiedene Temperaturen (T) ermittelt werden, die Kennlinien durch eine Funktion der Form A (I) x T + B (I) linearisiert werden, dass die so ermittelten Wertepaare A und B in einem Batteriemanagementsystem als Parameterfelder abgelegt werden, dass im Betrieb eines zu überwachenden baugleichen Akkumulators aus Messung von Temperatur und Ladestrom die zugehörige kritische Ladespannung berechnet wird, die zur Steuerung der Ladung des Akkumulators dient, dass an einem Akkumulator die der kritischen Ladespannung ($U_{krit}$) entsprechenden kritischen Ladezustände ($LZ_{krit}$) als Funktion von Ladestrom (I) und Batterietemperatur (T) ermittelt werden und die Daten als Parameterfelder im Batteriemanagementsystem gespeichert werden, und dass aus der Messung von Strom (I) und Temperatur (T) im Betrieb eines zu überwachenden baugleichen Akkumulators bei Erreichen der kritischen Ladespannung ($U_{krit}$), die dem kritischen Ladezustand ($LZ_{krit}$) entspricht, durch Vergleich mit den in den Parameterfeldern gespeicherten Daten, der Wert dieses kritischen Ladezustands ($LZ_{krit}$) ermittelt wird.

2. Verfahren nach Anspruch 1, **dadurch gekennzeichnet, dass** der zu überwachende Akkumulator in vorgegebenen Zeiten bis auf die kritische Ladespannung ($U_{krit}$) geladen wird.

**3.** Verfahren nach Anspruch 1, **dadurch gekennzeichnet, dass** das Akkumulatorensystem aus einem beliebigen Ladezustand heraus durch eine Nettoladung eine Erhöhung des Ladezustandes erfährt, und dass beim Erreichen des kritischen Ladezustandes ($LZ_{krit}$), dieser Ladezustandswert im Batterie-Managementsystem gespeichert wird, und beim weiteren Betrieb des Akkumulators dieser Wert als Reset-Wert für eine Ladezustandskontrolle mittels zeitlicher Strom-Integration verwendet wird.

**4.** Verfahren nach Anspruch 3, **dadurch gekennzeichnet, dass** die Ladezustandsbestimmung in festen zeitlichen Intervallen oder nach Durchsatz einer bestimmten Ladungsmenge durchgeführt wird.

## Claims

**1.** Method for monitoring the charge of gas-tight alkaline rechargeable batteries, **characterized in that** the characteristics of the critical charge voltage($U_{crit}$) of a rechargeable battery are determined as a function of the charging current (I) for various temperatures (T), the characteristics are linearized using a function in the form $A(I) \times T + B(I)$, **in that** the value couples A and B determined in this way are stored as parameter fields in a battery management system, **in that** the associated critical charge voltage is calculated from measurement of the temperature and charging current during operation of a physically identical rechargeable battery that is to be monitored, and this charge voltage is used to control the charging of the rechargeable battery, **in that** the critical states of charge ($LZ_{crit}$) which correspond to the critical charge voltage ($U_{crit}$) on a rechargeable battery are determined as a function of the charging current (I) and the battery temperature (T) and the data is stored as parameter fields in the battery management system, and **in that** the value of this critical state of charge ($LZ_{crit}$) is determined from the measurement of the current (I) and the temperature (T) during operation of a physically identical rechargeable battery that is to be monitored, on reaching the critical charge voltage ($U_{crit}$), which corresponds to the critical state of charge ($LZ_{crit}$), by comparison with the data stored in the parameter fields.

**2.** Method according to Claim 1, **characterized in that** the rechargeable battery to be monitored is charged at predetermined times up to the critical charge voltage ($U_{crit}$).

**3.** Method according to Claim 1, **characterized in that** the state of charge of the rechargeable-battery system is increased by a net charge from any given state of charge, and **in that**, on reaching the critical state of charge ($LZ_{crit}$), this state of charge value is stored in the battery management system and, during further operation of the rechargeable battery, this value is used as the reset value for state of charge monitoring, by means of current integration over time.

**4.** Method according to Claim 3, **characterized in that** the state of charge is determined at fixed time intervals or after a specific amount of charge has been passed.

## Revendications

**1.** Procédé de surveillance de la charge d'accumulateurs alcalins étanches aux gaz, **caractérisé en ce que** sur un accumulateur, les caractéristiques de la tension de charge critique (Ukrit) sont déterminées comme fonction du courant de charge (I) pour différentes températures (T), les caractéristiques sont linéarisées par une fonction ayant la forme A (I) x T + B (I), les paires de valeurs aléatoires A et B ainsi déterminées sont déposées comme champs de paramètres dans un système de gestion de batterie, pendant le fonctionnement d'un accumulateur identique à surveiller on calcule à partir de la mesure de température et de courant de charge, la tension de charge critique associée servant à commander la charge de l'accumulateur sur un accumulateur les états de charge critiques (LZkrit) correspondants à la tension de charge critique (Ukrit) sont déterminés comme fonction de la tension de charge (I) et de la température de la batterie (T) et les données sont mémorisées dans le système de gestion de batterie comme champs de paramètres, et la valeur de cet état de charge critique (LZkrit) est déterminée à partir de la mesure de courant (I) et de température (T) pendant le fonctionnement d'un accumulateur identique à surveiller, lorsque la tension de charge critique (Ukrit) qui correspond à l'état de charge (LZkrit) a été atteinte, par la comparaison avec les données mémorisées dans les champs de paramètres.

**2.** Procédé selon la revendication 1, **caractérisé en ce que** l'accumulateur à surveiller est chargé jusqu'à la tension de charge critique (Ukrit) dans les temps prescrits.

**3.** Procédé selon la revendication 1, **caractérisé en ce que** le système d'accumulateurs connaît une augmentation de l'état de charge par une charge nette à partir d'un quelconque état de charge, et lorsque l'état de charge critique (LZkrit) a été atteint, cette valeur d'état de charge est mémorisée dans le système de gestion de batterie, et lors d'un autre fonctionnement de l'accumulateur cette valeur est utilisée comme valeur de remise à zéro pour un contrôle de l'état de charge au moyen d'une intégration de courant temporaire.

**4.** Procédé selon la revendication 3, **caractérisé en ce que** la détermination de l'état de charge est effectuée dans des intervalles de temps fixes ou après production d'une certaine quantité de charge.

Figur 1

Figur 2

**U$_{KRIT}$/V**

$I1 = -0,0034T + 1,6034$

$I2 = -0,0041T + 1,6571$

$I5 = -0,0051T + 1,7515$

$I10 = -0,0059T + 1,8564$

$\mathbf{I_{10}}$

$\mathbf{I_5}$

$\mathbf{I_2}$

$\mathbf{I_1}$

**T/°C**

**Figur 3**

**U$_{KRIT}$ (0°C) /V = B**

**I /C**

**Figur 4**

$$\Delta U_{KRIT} / T \ / V = A$$

**Figur 5**

**Figur 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5012176 A